Europäisches Patentamt

European Patent Office

Office européen des brevets

(11) Publication number: **0 416 320 A2**

# EUROPEAN PATENT APPLICATION

(21) Application number: 90115383.3

(22) Date of filing: 10.08.90

(51) Int. Cl.5: **H01L 27/146**

(30) Priority: 06.09.89 US 403536

(43) Date of publication of application:
**13.03.91 Bulletin 91/11**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **Luttmer, Joseph D.
2412 Buttercup Drive
Richardson, Texas 75082(US)**
Inventor: **Kinch, Michael A.
7230 La Manga Drive
Dallas, Texas 75248(US)**

(74) Representative: **Leiser, Gottfried, Dipl.-Ing. et
al
Patentanwälte Prinz, Leiser, Bunke & Partner
Manzingerweg 7
W-8000 München 60(DE)**

(54) Infrared detector and method.

(57) Channel stops for MIS infrared photodetector devices in $Hg_{1-x}Cd_xTe$ by lattice damage (254) between MIS gates (252).

Fig. 3

# INFRARED DETECTOR AND METHOD

## CROSS-REFERENCE TO RELATED APPLICATIONS

Copending U.S. Application Serial No. 769,993, filed 8/26/85, (Kinch and Simmons) and cofiled application Serial No. (Docket 13726) disclose related subject matter. These cross-referenced applications are assigned to the assignee of this application.

## BACKGROUND OF THE INVENTION

### 1. Field of the Invention.

The present invention relates to infrared radiation detectors and, more particularly, to small bandgap semiconductor infrared detectors and methods of fabrication.

### 2. Description of the Related Art.

Detection of infrared radiation emitted by warm bodies provides an important method for night vision (perception without visible light). Infrared detectors are of various types and include small bandgap semiconductors structured as photodiodes or photocapacitors. Alloys of mercury telluride and cadmium telluride, generically denoted $Hg_{1-x}CD_xTe$, are extensively employed as the photosensitive semiconductor in such detectors. Indeed, $Hg_{0.8}Cd_{0.2}Te$ has a bandgap of about 0.1 eV which corresponds to a photon wavelength of 12 $\mu$m and $Hg_{0.73}Cd_{0.27}Te$ has a bandgap of about 0.24 eV corresponding to a photon wavelength of 5 $\mu$m; and these two wavelengths are in the two atmospheric windows of greatest interest for infrared detectors.

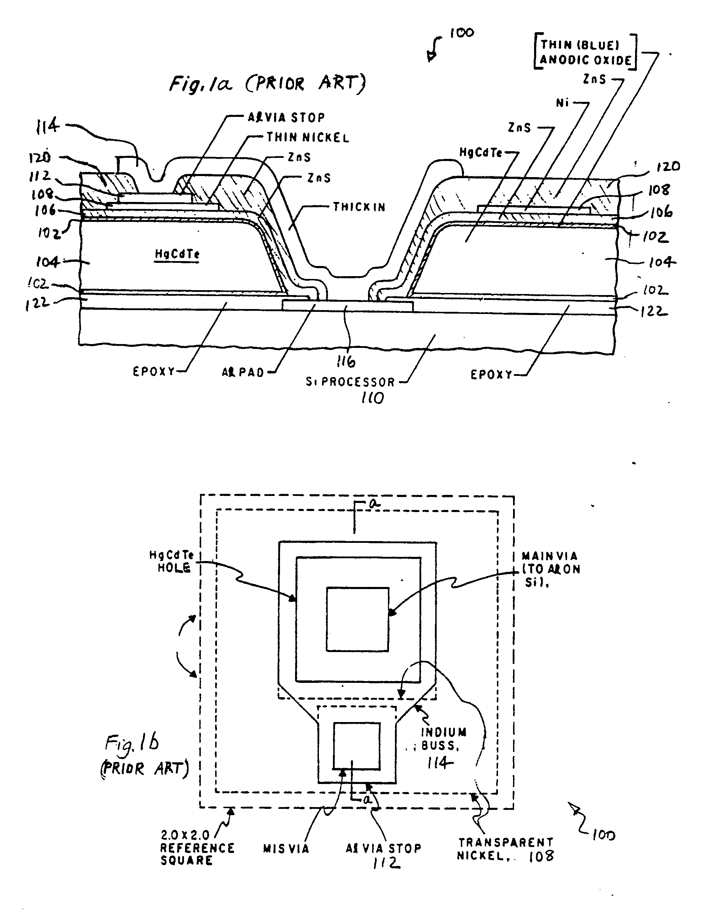

An infrared imager incorporating an array of MIS photocapacitor detectors in $Hg_{1-x}Cd_xTe$ is disclosed in U.S.Pat.No. 4,684,812 (Tew and Lewis). Figures 1a-b are cross sectional elevation and plan views of a single photocapacitor and illustrate the anodic oxide passivation of the $Hg_{1-x}Cd_xTe$. Anodic oxidation of $Hg_{1-x}Cd_xTe$ provides a passivation layer made of primarily $HgTeO_3$, $CdTeO_3$, and $TeO_2$ on the surface of the $Hg_{1-x}Cd_xTe$ (typically the layer is grown to a thickness of 700 Å), and this oxide passivation layer typically includes substantial a trapped positive charge with areal density of roughly $1 \times 10^{12}/cm^2$. The trapped charge acts as a channel stop in that it accumulates electrons at the oxide-$Hg_{1-x}Cd_xTe$ interface and deters inversion in $n$ type $Hg_{1-x}Cd_xTe$. This achieves maximum usable potential well capacity and integration time.

However, the anodic oxide passivation layer is thermodynamically unstable and sulfide passivation layers (primarily CdS plus some HgS) are replacing oxide passivation layers; see U.S.Pat.No. 4,632,886 (Teherani and Simmons). Sulfide passivation layers have the drawback of not incorporating substantial positive fixed charge, and various approaches have been used to control surface currents. One approach is to etch away the sulfide passivation layer in channel stop areas and grow anodic oxide to regain the fixed positive charge, but this has the problem of extra wet processing steps. Alternatively, a field plate may be incorporated into the imager and biased to induce a channel stop, but this has the problems of a more complicated structure and processing sequence.

Infrared detectors based on photodiodes in $Hg_{1-x}Cd_xTe$ require formation of $p$-$n$ junctions in $Hg_{1-x}Cd_xTe$, and such junctions are frequently made by ion implanting species such as boron into $p$ type $Hg_{1-x}Cd_xTe$. Prior to annealing, the implanted region has strong $n$ type doping even for very small implanted doses of each kind of implanted ion (donor, acceptor, inert) and the carrier concentration increases with implant dose but rapidly reaches a saturation in sheet donor concentration of $2 \times 10^{14}{}_2/cm^2$. See, G.Destefanis, 86 J.Crystal Growth 700 (1988) at 705.

## SUMMARY OF THE INVENTION

The present invention provides channel stops in $Hg_{1-x}Cd_xTe$ and related compounds by lattice damage implants or ion milling. In preferred embodiments, boron is implanted through sulfide (CdS, HgS) passivation and ZnS dielectric on n type $Hg_{1-x}Cd_xTe$ to form $n^+$ accumulated channel stops. Other preferred embodiments ion mill the sulfide passivation and dielectric on $n$ type $Hg_{1-x}Cd_xTe$ and then damage the $Hg_{1-x}Cd_xTe$ to form $n^+$ accumulated channel stops. This solves the problems of the known methods of channel stop formation with nonanodic oxide passivation.

## BRIEF DESCRIPTION OF THE DRAWINGS

The drawings are schematic for clarity.
Figures 1a-b are cross sectional elevation and plan views of a prior art infrared photocapcitive detector;
Figure 2 shows the anodic oxide channel stop of the prior art detector;

Figure 3 shows the first preferred embodiment channel stop;

Figures 4a-b illustrate the steps of a first preferred embodiment method of fabrication;

Figures 5a-c show steps in a second preferred embodiment method;

Figures 6a-c show steps in a third preferred embodiment method;

Figure 7 is a cross sectional elevation view of second preferred embodiment channel stop;

Figures 8a-b illustrate the steps of a preferred embodiment method of fabrication of the second preferred embodiment channel stop; and

Figure 9 compares the capacitance-voltage behavior of HgCdTe MIS devices with and without a preferred embodiment channel stop.

## DESCRIPTION OF THE PREFERRED EMBODIMENTS

Figures 1 a-b illustrate in cross sectional elevation and plan views a single pixel (denoted by reference numeral 100) of a prior art $Hg_{1-x}Cd_xTe$ photocapacitive infrared imager and show anodic oxide passivation 102 of $Hg_{1-x}Cd_xTe$ 104 together with ZnS gate dielectric 106 and nickel gate 108. Figure 1a is a section taken along line a-a in Figure 1b. The Figures also indicate the underlying silicon processor 110 for the imager, the metal connection (112-114-116) of gate 108 to silicon processor 110, ZnS insulation 120, and epoxy 122 affixing the $Hg_{1-x}Cd_xTe$ to the silicon processor.

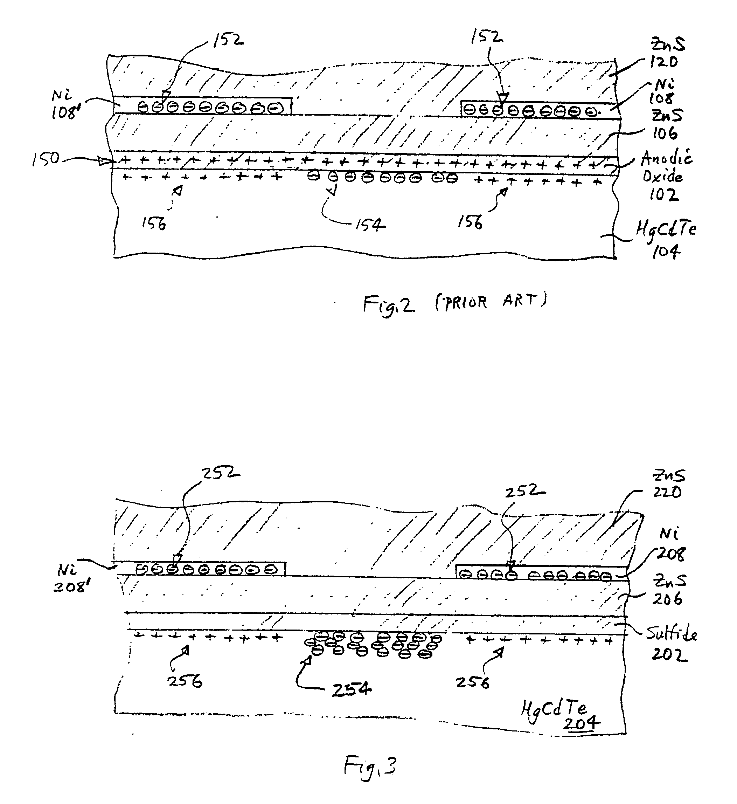

Figure 2 is an enlarged portion of the cross sectional elevation view as in Figure 1a, but showing two adjacent gates, 108 and 108', of two adjacent pixels together with the accumulated channel stop between them. Anodic oxide 102 is about 700 Å thick, gate dielectric ZnS 106 is about 1500 Å thick, semitransparent nickel gates 108 and 108' are each about 70 Å thick and separated laterally by about 10 μm. Each pixel is about 50 μm square (including the channel stop). The fixed positive charge in anodic oxide 102 is heuristically indicated by the +'s 150, the negative bias on gates 108 and 108' by the ⊖'s 152, the accumulated electrons in $Hg_{1-x}Cd_xTe$ 104 forming the channel stop by ⊖'s 154, and the potential wells in the $Hg_{1-x}Cd_xTe$ under the gates by +'s 156. Without the fixed positive charge in anodic oxide 102, the surface region of $Hg_{1-x}Cd_xTe$ 104 between the gates 108 and 108' would be neutral or slightly depleted, and minority carrier holes in $Hg_{1-x}Cd_xTe$ 104 which are stored in the potential well created by the bias on gate 108 could diffuse along the surface to the potential well created by the bias on gate 108', and vice versa, and thereby disrupt the infrared detection.

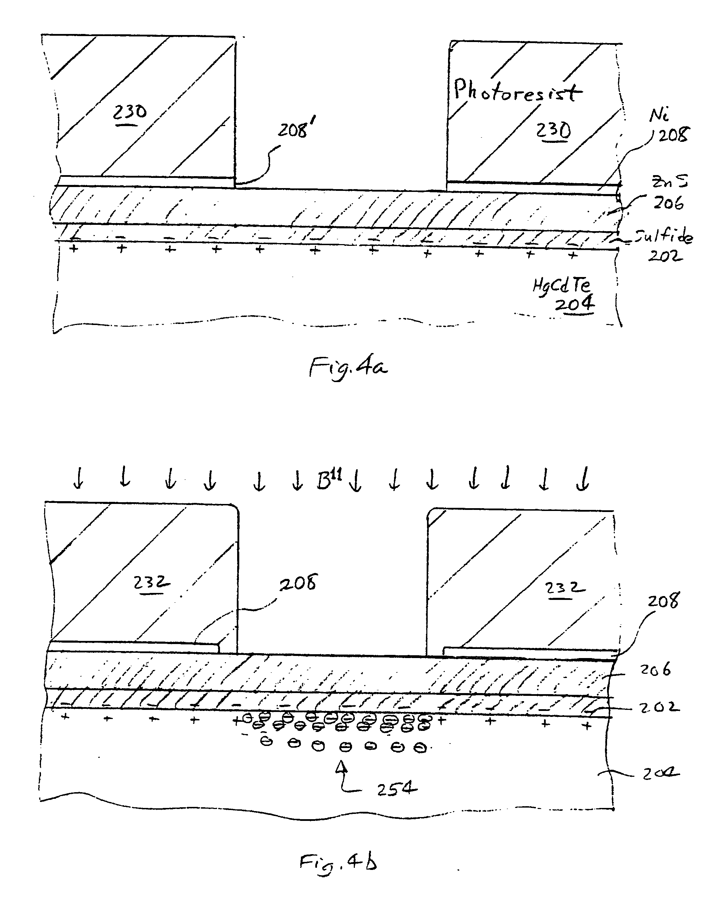

The first preferred embodiment channel stop is illustrated in Figure 3 (a view analogous to that of Figure 2) which shows $n$ type $Hg_{1-x}Cd_xTe$ 204 with passivation sulfide 202 of thickness 200 Å, ZnS dielectric 206 of thickness 1500 Å, semitransparent nickel gates 208 and 208' of thickness 70 Å are laterally separated by about 10 μm, and insulation ZnS 220. Again, the negative bias on gates 208 and 208' is heuristically indicated by ⊖'s 252, the induced potential wells in $Hg_{1-x}Cd_xTe$ 204 by +'s 256, and boron implanted into $Hg_{1-x}Cd_xTe$ 204 between gates 208 and 208' by ⊖'s 254. The sulfide passivation 202 fails to provide a fixed positive charge to accumulate the surface of $Hg_{1-x}Cd_xTe$ 204 between gates 208 and 208'. However, the implanted boron converts $Hg_{1-x}Cd_xTe$ 204 to $n^+$ - (suggested by the 0's 254) which possesses a higher threshold voltage for surface inversion (but still has the same flatband voltage) and hence provides a channel stop between the potential wells.

The first preferred embodiment imager is similar to the prior art imager with pixels illustrated in Figures 1a-b, but with sulfide passivation and first preferred embodiment channel stops.

Figures 4a-b illustrate the following steps in a first preferred embodiment method of fabrication of the first preferred embodiment channel stops (and imagers).

(a) Begin with sulfide passivated substrate 204 of $n$ type $Hg_{0.8}Cd_{0.2}Te$ with a carrier concentration of about $10^{15}/cm^3$ at 77 K; substrate 204 may already be epoxied to a silicon processor and have vias for fabrication of the first preferred embodiment hybrid imager. Sulfide passivation layer 202 may have been formed by any convenient method, such as anodic sulfidization or plasma sulfidization, and has a thickness of 200 Å and a composition of primarily CdS with some HgS, depending upon the method of formation used. Next deposit 1500 Å of ZnS 206 gate dielectric by MOCVD or any other convenient method. Deposit by evaporation a nickel layer of thickness about 70 Å. Spin on photoresist 230, and expose it to define the locations for the gates of the imager. Develop photoresist 230, and use it as an etch mask to etch the nickel layer to form the gates; gates 208 and 208' are shown in Figure 4a. Sulfide 202 may have a small, negative fixed charge, and the $Hg_{0.8}Cd_{0.2}Te$ at the interface of sulfide 202 and substrate 204 may be depleted or even possibly inverted. This is suggested by the +'s and -'s.

(b) Strip photoresist 230 and spin on photoresist 232; expose photoresist 232 to define the channel stops. Implant boron (isotope 11) at 75 KeV and a dose of $10^{13}$ ions/cm². The boron has a projected range of about 2000 Å, and penetrates ZnS 206 and sulfide 202 with the peak boron concentration about at about 300 Å below the interface of sulfide 202 and substrate 204. The projected straggle of the implant is about 800 Å, so at least 1100 Å of $Hg_{1-x}Cd_xTe$ 204 at the interface is heavily implanted and consequently doped $n^+$ with a carrier concentration on the order of about $10^{17}$/cm³ near the surface and at 77 K. See Figure 4b which indicates the boron implant caused doping with ө's 254. Note that photoresist 230 could not have been used for the boron implant because the channel stop then would have extended slightly under the gates 208 and 208′ and degraded performance. Photoresist 232 extends about 1 μm beyond gates 208 and 208′ to provide an offset between channel stop 254 and depletion regions under the gates.

(c) Strip photoresist 232 and deposit ZnS insulation layer 220 of thickness 3000 Å. Use photoresist to etch openings in ZnS 220 to the gates and to the underlying silicon processor. Deposit metal and pattern it with photoresist and etch it to form the connections from the gates to the silicon processor. This completes the imager.

Second preferred embodiment method of fabrication of the preferred embodiment channel stops (and imagers) includes the following steps:

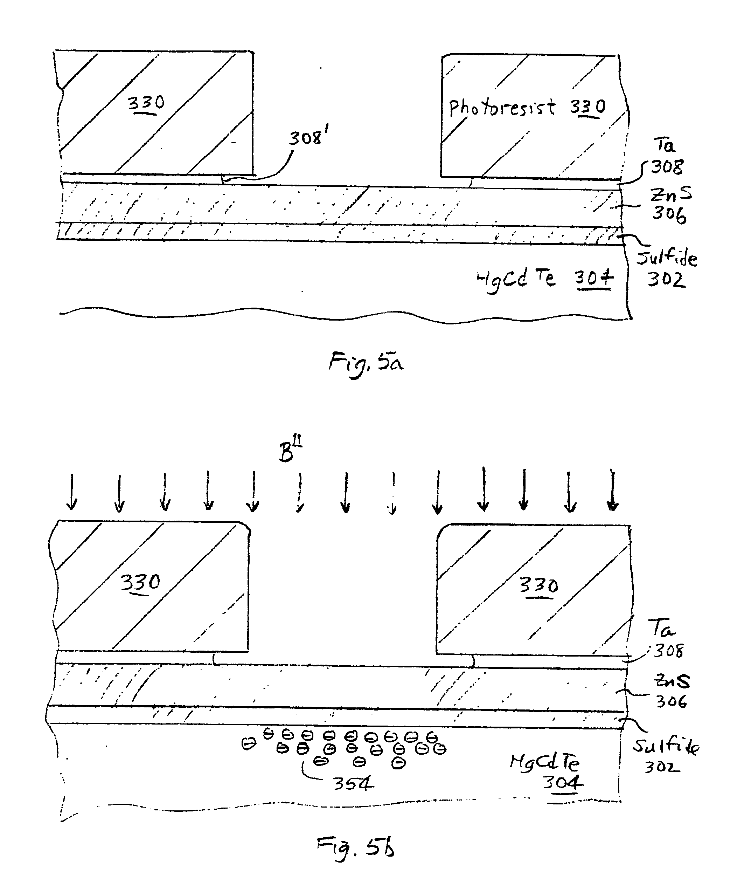

(a) Begin with sulfide passivated substrate 304 of $n$ type $Hg_{0.8}Cd_{0.2}Te$; sulfide passivation layer 302 has a thickness of 200 Å and a composition (primarily CdS with some HgS) and fixed charge (from essentially zero to negative about 2 x $10^{11}$/cm2) depending upon the method of formation used. Next deposit 1500 Å of ZnS 306 gate dielectric by MOCVD or any other convenient method. Deposit by sputtering a tantalum layer of thickness about 1000 Å. Spin on photoresist 330, and expose it to define the locations for the gates of the imager. Develop photoresist 330, and use it as an etch mask to plasma etch the tantalum layer with $CF_4$ to form the gates. This etch is isotropic and undercuts the tantalum as illustrated in Figure 5a; overetching by 1000% yields an undercut of about 1.0 μm. The selectivity of the etch for tantalum relative to ZnS 306 is about 200 to 1; but even if a few hundred Å of ZnS 306 are removed during the overetch, the subsequent deposition of ZnS 320 will compensate for the loss. See Figure 5a showing gates 308 and 308′.

(b) Implant boron (isotope 11) at 75 KeV and a dose of $10^{13}$ ions/cm² using photoresist 330 as the implant mask. The boron has a projected range of about 2000 Å, and penetrates ZnS 306 and sulfide 302 with the peak boron concentration about at about 300 Å below the interface of sulfide 302 and substrate 304. The projected straggle of the implant is about 800 Å, so at least 1100 Å of $Hg_{1-x}Cd_xTe$ 304 at the interface is heavily implanted and consequently doped $n^+$. The lateral straggle is somewhat less than the projected straggle, so the 1.0 μm overhang of photoresist 330 on gates 308 and 308′ is sufficient to prevent the implant from extending under the gates. See Figure 5b which indicates the boron implant caused doping with ө's 354.

(c) Strip photoresist 330 and deposit ZnS insulation layer 320 and complete the imager as previously described.

Note that the same undercut etch of the gate level metal can be used to form a self-aligned field plate: in place of the implant of boron in step (b) an evaporation of metal (see Figure 5c) followed by liftoff of the photoresist will yield a field plate 370 aligned to the gates 308 and 308′. The separation between the gates and the field plate is determined by the amount of undercut during the etch of the gate level metal.

Third preferred embodiment method of fabrication of the preferred embodiment channel stops (and imagers) includes the following steps illustrated in cross sectional elevation view:

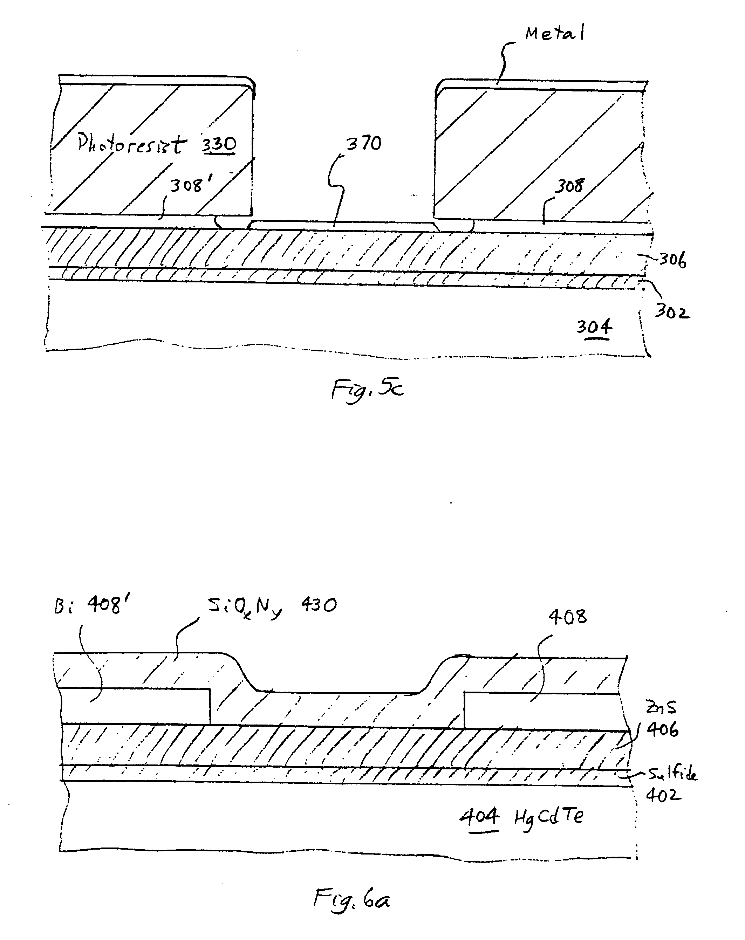

(a) Begin with sulfide passivated substrate 404 of $n$ type $Hg_{0.8}Cd_{0.2}Te$; sulfide passivation layer 402 has a thickness of 200 Å and a composition (primarily CdS with some HgS) and fixed charge (from essentially zero to negative about 2 x $10^{11}$/cm²) depending upon the method of formation used. Next deposit 1000 Å of ZnS 406 gate dielectric by MOCVD or any other convenient method. Deposit a conductive layer of thickness about 5000 Å. Spin on photoresist and expose it to define the locations for the gates of the imager. Develop the photoresist and use it as an etch mask to plasma etch the conductive layer to form the gates. Deposit conformal layer 430 of silicon dioxide or silicon nitride (or silicon oxynitride) of thickness about 10,000 Å; see Figure 6a showing gates 408 and 408′.

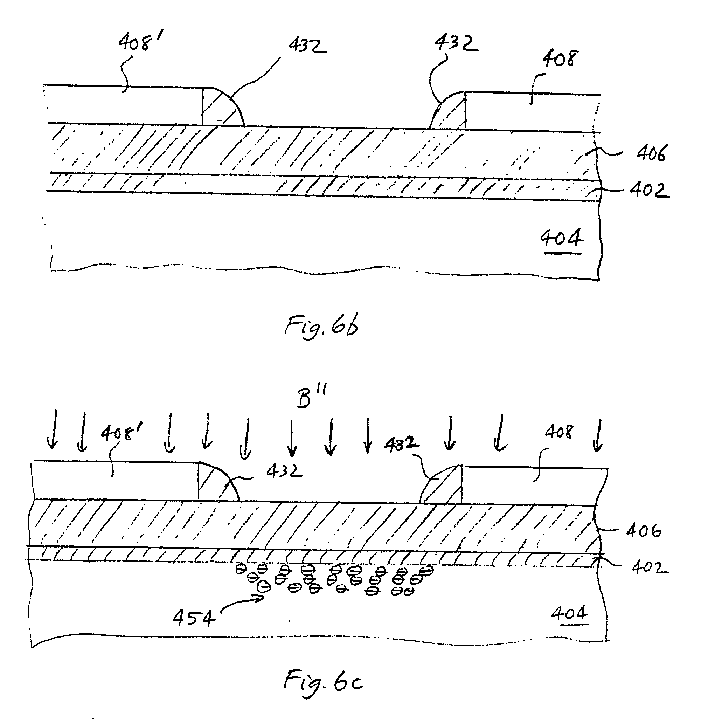

(b) Anisotropically etch silicon oxynitride layer 430 to leave sidewall filaments 432 on the edges of the gates. See Figure 6b; the sidewall filaments are about 10,000 Å wide.

(c) Implant boron at 50 KeV and a dose of $10^{13}$ ions/cm² using the gates plus sidewall filaments of silicon oxynitride as the implant mask. This is analogous to the sidewall oxide spacer approach to source/drain implantation in MOSFET fabrication. The boron has a projected range of about 1500 Å, and penetrates ZnS 406 and sulfide 402 with the peak boron concentration about at about 300 Å below the interface of sulfide 402 and substrate 404. The projected straggle of the implant is about 600 Å, so at least 900 Å of $Hg_{1-x}Cd_xTe$ 404 at the interface is heavily implanted and consequently doped $n^+$. The lateral straggle is somewhat less than the projected straggle, so the 10,000 Å width of sidewall filaments 432 on gates 408 and 408' is sufficient to prevent the implant from extending under the gates. See Figure 6c which indicates the boron-implant-caused doping with $\ominus$'s 454. Note that gate 408 must be thick enough to prevent the implant from penetrating the gate plus ZnS and doping the $Hg_{1-x}Cd_xTe$ beneath the gate. However, a thick gate absorbs a greater fraction of the incident infrared radiation, so a thinning of gate 408 by a timed etch may be used after the implant.

(d) Deposit ZnS insulation layer 420 and complete the imager as previously described.

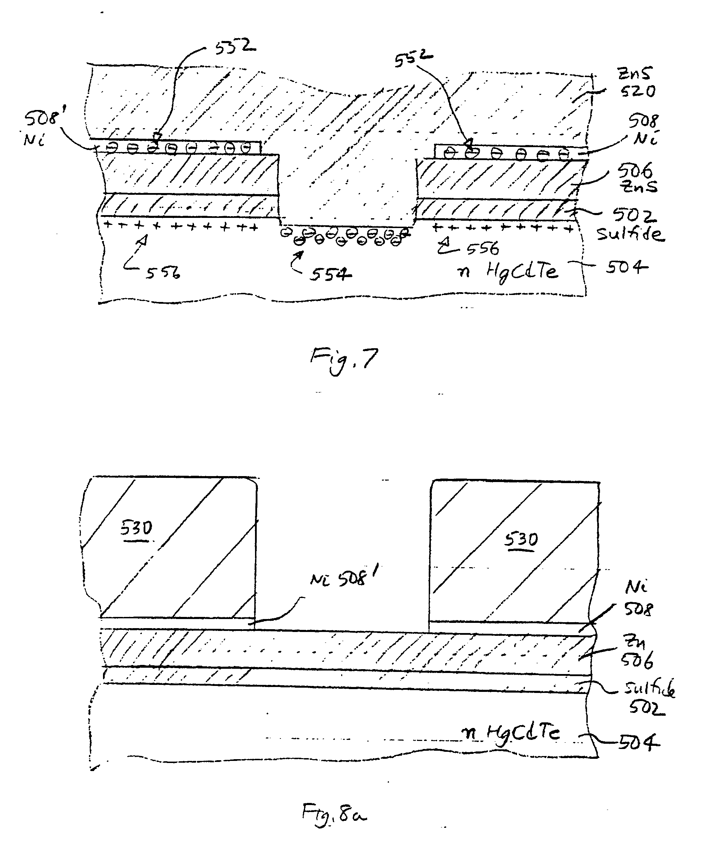

The second preferred embodiment channel stop is illustrated in Figure 7 (a view analogous to that of Figure 3) which shows $n$ type $Hg_{1-x}Cd_xTe$ 504 with passivation sulfide 502 of thickness 200 Å, ZnS dielectric 506 of thickness 1500 Å, semitransparent nickel gates 508 and 508' of thickness 100 A are laterally separated by about 10 $\mu$m, and insulation ZnS 520. The negative bias on gates 508 and 508' is heuristically indicated by $\ominus$'s 552, the induced potential wells in $Hg_{1-x}Cd_xTe$ 504 by +'s 556, and lattice damaged $Hg_{1-x}Cd_xTe$ 504 between gates 508 and 508' by $\ominus$'s 554. The sulfide passivation 502 fails to provide a fixed positive charge to accumulate the surface of $Hg_{1-x}Cd_xTe$ 504 between gates 508 and 508'. However, the latticed damaged $Hg_{1-x}Cd_xTe$ 504 is effectively doped $n^+$ - (suggested by the $\ominus$'s 554) and provides a channel stop between the potential wells.

Figures 8a-b illustrate the following steps in a preferred embodiment method of fabrication of the second preferred embodiment channel stops (and imagers).

(a) Begin with sulfide passivated substrate 504 of $n$ type $Hg_{0.8}Cd_{0.2}Te$; substrate 504 may already be epoxied to a silicon processor and have vias for fabrication of the first preferred embodiment hybrid imager. Sulfide passivation layer 502 may have been formed by any convenient method, such as anodic sulfidization or plasma sulfidization, and has a thickness of 200 Å and a composition of primarily CdS with some HgS, depending upon the method of formation used. Next deposit 1500 Å of ZnS 506 gate dielectric by MOCVD or any other convenient method. Deposit by evaporation a nickel layer of thickness about 70 Å. Spin on photoresist 530, and expose it to define the locations for the gates of the imager. Develop photoresist 530, and use it as an etch mask to etch the nickel layer to form the gates; This is the same as with the first preferred embodiment channel stop fabrication as shown in Figure 4a; see Figure 8a. Sulfide 502 may have a small, negative fixed charge, and the $Hg_{0.8}Cd_{0.2}Te$ at the interface of sulfide 502 and substrate 504 may be depleted or even possibly inverted.

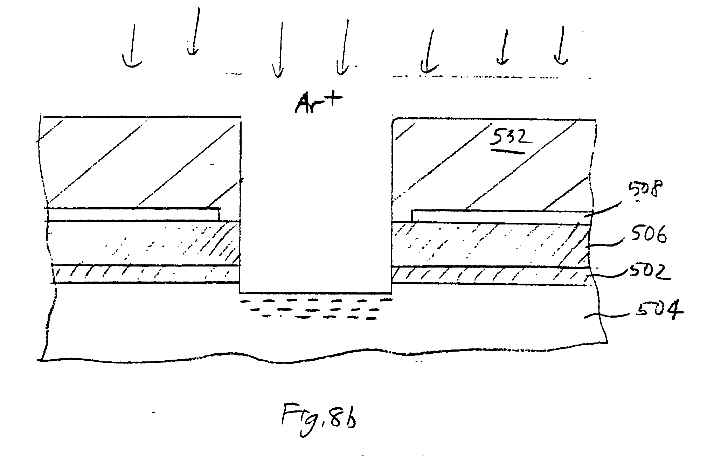

(b) Strip photoresist 530 and spin on photoresist 532; expose photoresist 532 to define the channel stops. Ion mill with argon ions, the exposed ZnS 506, sulfide passivation 502, and some $Hg_{0.8}Cd_{0.2}Te$ 504 are removed together with the top of photoresist 532; see Figure 8b. The ion milling also damages the lattice of $Hg_{0.8}Cd_{0.2}Te$ 504 and thereby effectively converts the $Hg_{0.8}Cd_{0.2}Te$ to $n^+$; this is indicated by $\ominus$'s 554. The depth of the damage is a function of ion mill dose and energy. Photoresist 532 extends about 1 $\mu$m beyond gates 508 and 508' to provide an offset between channel stop 554 and depletion regions under the gates. The amount of removal of $Hg_{0.8}Cd_{0.2}Te$ 504 by the ion milling is determined by uniformity across wafer, and will be just a few tens of Å.

(c) Strip photoresist 532 and deposit ZnS insulation layer 520 of thickness 3000 Å; this fills the ion milled opening in ZnS 506 and sulfide passivation 502 while still providing a relatively Bat surface. Use photoresist to etch openings in ZnS 520 to the gates and to the underlying silicon processor. Deposit metal and pattern it with photoresist and etch it to form the connections from the gates to the silicon processor. This completes the imager.

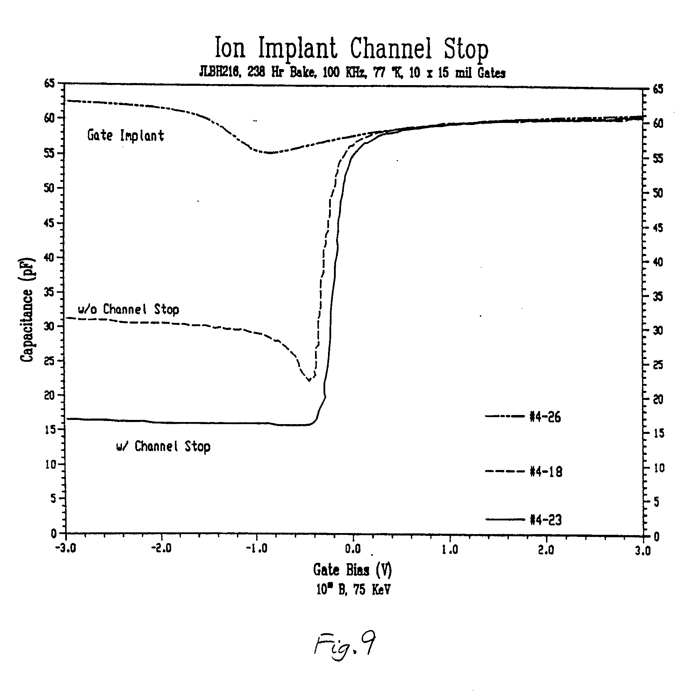

Both the implant channel stop and the ion mill lattice damage channel stop yield improved detector characteristics for passivations that deplete the $Hg_{1-x}Cd_xTe$. For passivations that slightly accumulate the $Hg_{1-x}Cd_xTe$, the implant and ion mill channel stops do not degrade detector characteristics; this indicates that the lattice damage from the implant or ion mill does not propagate under the gate. Figure 9 shows ion implanted channel stops provided high frequency capacitance-voltage characteristics for a detector, whereas a comparable detector without channel stops showed low frequency capacitance-voltage characteristics. The capacitance-voltage characteristic of the gate implant region clearly shows the threshold voltage for surface inversion has moved to a larger negative value, thus providing a channel stop capability for the active gates.

## MODIFICATIONS AND ADVANTAGES

Various modifications of the preferred embodiment devices and methods may be made while retaining the features of lattice damage channel stops.

For example, the dimensions and shapes of the detectors may be varied, the material may be HgCdZnTe, HgMnZnTeSe, or other II-VI narrow bandgap semiconductors, the implanted species or ion milling species may be any convenient ion, although light ions such as boron have a greater projected range for the same energy,

The invention provides the advantages of simple and process-compatible channel stops.

**Claims**

1. An infrared imager, comprising:
   (a) a layer of semiconductor material with bandgap comparable to the energy of infrared photons to be detected;
   (b) an array of insulated gates on said layer;
   (c) channel stops between said gates, said channel stops characterized by lattice damage in said layer; and
   (d) circuitry connected to said gates.

2. The imager of claim 1, wherein:
   (a) said material is $n$-type $Hg_{1-x}Cd_xTe$; and
   (b) said lattice damage is from implanted ions.

3. The imager of claim 2, further comprising:
   (a) at least one insulation layer on said semiconductor layer; and
   (b) said implanted ions are boron with a distribution characterized by implantation through said at least one insulation layer with peak in said semiconductor layer.

4. The imager of claim 3, wherein:
   (a) said at least one insulation layer includes ZnS on a sulfide passivation layer on said semiconductor layer.

5. The imager of claim 1, wherein:
   (a) said material is $n$-type $Hg_{1-x}Cd_xTe$; and
   (b) said lattice damage is from ion milling.

6. The imager of claim 5, further comprising:
   (a) at least one insulation layer on said semiconductor layer; and
   (b) said ion milling is characterized by argon ion milling through said at least one insulation layer on said semiconductor layer.

7. The imager of claim 6, wherein:
   (a) said at least one insulation layer includes ZnS on a sulfide passivation layer on said semiconductor layer.

8. A channel stop between devices in a semiconductor layer, comprising:
   (a) a layer of semiconductor material containing at least two devices; and
   (b) a lattice-damaged region in said layer between said at least two devices, said region forming a channel stop.

9. The channel stop of claim 8, wherein:
   (a) said layer of semiconductor material is $n$-type $Hg_{1-x}Cd_xTe$; and
   (b) said region is from implanted ions.

10. The channel stop of claim 9, further comprising:
    (a) at least one insulation layer on said semiconductor layer; and
    (b) said implanted ions are boron with a distribution characterized by implantation through said at least one insulation layer with peak in said semiconductor layer.

11. The channel stop of claim 10, wherein:
    (a) said at least one insulation layer includes ZnS on a sulfide passivation layer on said semiconductor layer.

12. The channel stop of claim 8, wherein:
    (a) said layer of semiconductor material is $n$-type $Hg_{1-x}Cd_xTe$; and
    (b) said region is from ion milling.

13. The channel stop of claim 12, further comprising:
    (a) at least one insulation layer on said semiconductor layer; and
    (b) said ion milling is characterized by argon ion milling through said at least one insulation layer on said semiconductor layer.

14. The channel stop of claim 13, wherein:
    (a) said at least one insulation layer includes ZnS on a sulfide passivation layer on said semiconductor layer.

15. A method of forming channel stops between semiconductor devices, comprising the step of:
    (a) damaging the lattice of a semiconductor layer in a region between two devices formed in said layer.

16. The method of claim 15, wherein:
    (a) said layer of semiconductor is $n$-type $Hg_{1-x}Cd_xTe$; and
    (b) said damaging is by implanting boron.

17. The method of claim 16, wherein:
    (a) said boron is implanted through at least one insulation layer on said semiconductor layer with the implant peak in said semiconductor layer.

18. The method of claim 15, wherein:
    (a) said layer of semiconductor is $n$-type $Hg_{1-x}Cd_xTe$; and
    (b) said damaging is by ion milling.

19. The method of claim 18, wherein:
    (a) said ion milling is through at least one insulation layer on said semiconductor layer.

Fig. 1a (PRIOR ART)

Fig. 1b (PRIOR ART)

152       152       ZnS
120

Ni
108'

Ni
108

ZnS
106

150

Anodic
Oxide
102

156      154      156

HgCdTe
104

Fig. 2 (PRIOR ART)

252       252       ZnS
220

Ni
208

Ni
208'

ZnS
206

Sulfide
202

256      254      256

HgCdTe
204

Fig. 3

**230**

**208'**

Photoresist **230**

Ni 208

ZnS 206

Sulfide 202

HgCdTe **204**

Fig. 4a

$B^{11}$

**232**

208

**232**

208

206

202

254

202

Fig. 4b

Fig. 5a

Fig. 5b

Metal

Photoresist 330

370

308'

308

306

302

304

Fig. 5c

Bi 408'

$SiO_xN_y$ 430

408

ZnS
406

Sulfide
402

404 HgCdTe

Fig. 6a

408'    432         432         408

432    432

406

402

404

Fig. 6b

B"

408'    432    432    408

406

402

454    404

Fig. 6c

552

552

ZnS
520

508'
Ni

508
Ni

506
ZnS

502
sulfide

556

554

556
n HgCdTe

504

Fig. 7

530

530

Ni 508'

Ni
508

Zn
506

sulfide
502

n HgCdTe

504

Fig. 8a

Fig. 8b

## Ion Implant Channel Stop

JLBH216, 238 Hr Bake, 100 KHz, 77 °K, 10 x 15 mil Gates

Gate Bias (V)

$10^{8}$ B, 75 KeV

Fig. 9